# EUROPEAN PATENT SPECIFICATION

(11) **EP 3 742 878 B1**
(45) Date of publication and mention of the grant of the patent: **03.04.2024**
(21) Application number: 18901017.6
(22) Date of filing: 19.01.2018
(51) Int. Cl.: H05K 13/02, B65G 1/137, H05K 13/04

(54) **STORAGE DEVICE AND REEL STORAGE METHOD**
SPEICHERVORRICHTUNG UND ROLLENSPEICHERVERFAHREN
DISPOSITIF DE STOCKAGE ET PROCÉDÉ DE STOCKAGE DE BOBINE

(43) Date of publication of application: 25.11.2020
(73) Proprietor: Fuji Corporation, Chiryu-shi, Aichi 472-8686 (JP)
(72) Inventor: YAMAZAKI Atsushi, Chiryu-shi Aichi 4728686 (JP)
(74) Representative: Grünecker Patent- und Rechtsanwälte PartG mbB
(86) International application number: PCT/JP2018/001670
(87) International publication number: WO 2019/142336

(56) References cited:
- WO-A1-2015/088449
- JP-A- H1 056 295
- JP-A- 2005 235 952
- JP-A- 2010 074 066
- JP-A- 2014 075 423
- JP-A- 2014 197 594
- JP-A- 2017 105 631
- US-A- 6 047 874

## Description

### Technical Field

The present description discloses techniques relating to a storage device and a reel storage method.

### Background Art

Patent Literature 1 discloses a method for automatically redistributing at least either bins or bin loading units which are stored in a surface mount components storage container by use of an actuator such as a robot arm. Specifically, multiple bin loading units individually include a component tape reel. The actuator brings in a bin, a pallet, or a component tape reel to a predetermined position within the surface mount component storage container. Additionally, the actuator brings out a bin, a pallet or a component tape reel from a predetermined position within the surface mount components storage container. The apparatus known from WO2015088449 A1 has multiple tape reels (110a-c) that are coupled to a central hub (122) and provided with first and second tape reels. A first actuator (150) is coupled to the central hub to rotate the central hub about a first axis of rotation to rotate the first tape reel away from a feeding position while simultaneously rotating the second tape reel toward the feeding position. The feeding position corresponds to a location at which the flexible linear tape is fed from a component transfer system to a tape reel, or fed from the tape reel to the component transfer system.

### Patent Literature

Patent Literature 1: JP-T-2016-532315

### Summary of the Invention

### Technical Problem

A component mounter picks up a component supplied from a feeder in which a reel is detachably set and mounts the component on a board. For example, in the case of a cassette-type feeder, there may be a case in which a reel diameter is limited by the size of the feeder. Even with feeders other than such a cassette-type feeder, there may be a case in which the reel diameter is also limited by, for example, a demand for miniaturized reels. Since reels have various reel diameters, reel diameters need to be changed as required.

In view of these situations, the present description discloses a storage device and a reel storage method not only for rewinding a reel having a different reel diameter but also for loading and unloading a reel.

### Solution to Problem

The invention is defined by the features of claims 1 and 12.

Further embodiments are defined in the dependent claims.

### Advantageous Effects of the Invention

The storage device described above includes the reel storage container, the reel rewinding device, the storage space, the rewinding section, and the moving section. As a result, when it is necessary to rewind the component tape to the second reel, the storage device can rewind the component tape as required. In addition, the storage device can store the reel which is at least either of the first reel and the second reel in the storage space and unload the reel from the storage space when the reel is unloaded from the reel storage container. What is described about the storage device above is also true with the reel storage method.

### Brief Description of Drawings

[Fig. 1] Fig. 1 is a block diagram showing a configuration example of board work line 10L, component arrival area 20, and reel storage container 30 according to a first embodiment.
[Fig. 2a] Fig. 2a is a plan view showing an example of reel 22 mounted in cassette 23.
[Fig. 2b] Fig. 2b is a plan view showing an example of a state in which reel 22 mounted in cassette 23 is set in feeder 24.
[Fig. 2c] Fig. 2c is a plan view showing an example of a state in which reel 22 mounted in cassette 23 is set in feeder 24.
[Fig. 3a] Fig. 3a is a front view showing an example of reel storage container 30.
[Fig. 3b] Fig. 3b is a plan view showing the example of reel storage container 30.
[Fig. 4] Fig. 4 is a plan view showing an example of storage unit 34b.
[Fig. 5] Fig. 5 is a block diagram showing an example of a control block of storage device 80 according to the first embodiment.
[Fig. 6] Fig. 6 is a flowchart showing an example of a control procedure performed by storage device 80 according to the first embodiment.
[Fig. 7] Fig. 7 is a block diagram showing a configuration example of board work line 10L, component arrival area 20, reel storage container 30, feeder storage container 40, reel setting device 50, and conveyance device 60 according to a second embodiment.
[Fig. 8] Fig. 8 is a block diagram showing an example of a control block of storage device 80.
[Fig. 9] Fig. 9 is a flowchart showing an example of a control procedure performed by storage device 80 according to the second embodiment.
[Fig. 10] Fig. 10 is a plan view showing an arrangement example of board work lines 10L, reel storage container 30, and feeder storage container 40.

### Description of Embodiments

Embodiments of the present description will be described by reference to drawings. In the drawings showing embodiments, like reference signs are given to like constituent portions, and in this description, the repetition of similar descriptions will be omitted. In addition, what is described in the first embodiment can also be applied to the second embodiment.

### 1. First Embodiment

### 1-1. Board Work Line 10L

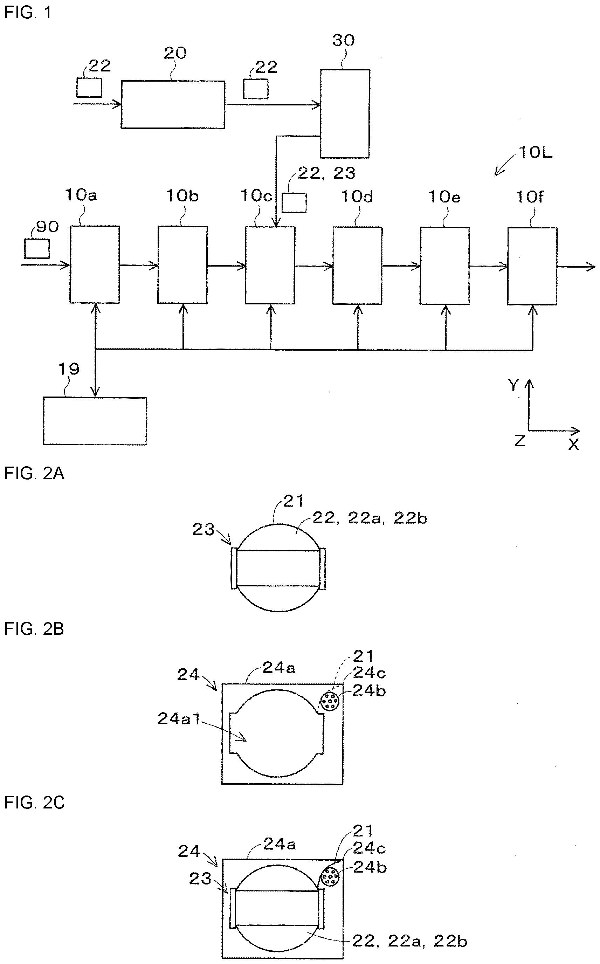

As shown in Fig. 1, reel 22, which has arrived at component arrival area 20, is stored in reel storage container 30 for supply to component mounter 10c in board work line 10L. Board work line 10L performs predetermined operations on board 90. In a first embodiment, board work line 10L includes multiple (six) work machines such as printer 10a, print inspecting machine 10b, component mounter 10c, external appearance inspecting machine 10d, reflow oven 10e, and function inspecting machine 10f. The multiple (six) work machines are arranged sequentially in the order of printer 10a, print inspecting machine 10b, component mounter 10c, external appearance inspecting machine 10d, reflow oven 10e, and function inspecting machine 10f as seen from an upstream side of board work line 10L. Board 90 is conveyed into printer 10a positioned at a starting end of board work line 10L. Then, board 90 is conveyed to a downstream end of board work line 10L by a board conveyance device (not shown) thereof and is conveyed out from function inspecting machine 10f positioned at a terminating end of board work line 10L.

Printer 10a prints solder paste on component mounting positions of board 90. Solder to be printed on board 90 has a predetermined viscosity and functions, once printed on board 90, as a bonding material for bonding board 90 and a component mounted on board 90 together. Print inspecting machine 10b inspects board 90 for a printed state of solder printed on board 90 by printer 10a. Component mounter 10c mounts a component on the solder printed by printer 10a. There may be one or multiple component mounters 10c. In the case that multiple component mounters 10c are provided, these multiple component mounters 10 can share the component mounting work.

Component mounter 10c includes a component supply device (not shown) for supplying components. The component supply device can supply components by use of, for example, feeders 24, trays (not shown), and the like. Reel 22 is detachably mounted in feeder 24. As shown in Fig. 2a, component tape 21, housing components, is wound around reel 22. Component tape 21 may be paper tape or embossed tape. In the present embodiment, reel 22 is detachably mounted in cassette 23. Cassette 23 can take various forms and shapes, provided that cassette 23 can hold reel 22 detachably. Cassette 23 includes a first portion (for example, an upper portion) and a second portion (for example, a lower portion) and can hold reel 22 in such a manner as to hold reel 22 by the first portion and the second portion. Additionally, cassette 23 can hold reel 22 with a fixing portion (for example, a projecting portion).

As shown in Fig. 2c, in the present embodiment, reel 22 is provided rotatably and detachably in feeder 24 while being mounted in cassette 23. As shown in Fig. 2b, feeder 24 includes main body section 24a, sprocket 24b for feeding component tape 21 pitch by pitch, and component pickup section 24c. Main body section 24a includes storage section 24a1 formed so as to store reel 22 mounted in cassette 23. Additionally, a support portion (not shown) is provided on main body section 24a, and reel 22 mounted in cassette 23 can rotate relative to feeder 24 by the support portion supporting cassette 23.

Sprocket 24b is rotated by a driving device (not shown) such as a stepping motor so as to feed component tape 21 pitch by pitch. A leading end portion of component tape 21 fed pitch by pitch is pulled out to component pickup section 24c, whereby components are supplied sequentially. Reel 22 can supply, for example, relatively small components such as chip components. In the present embodiment, component mounter 10c picks up a component supplied from feeder 24 in which reel 22 is detachably set and mounts the component on board 90.

External appearance inspecting machine 10d inspects board 90 for a mounted state of the component mounted on board 90 by component mounter 10c. Specifically speaking, external appearance inspecting machine 10d recognizes a mounted state of the component on board 90 including whether the component mounted on board 90 is appropriate, as well as the mounting position and posture of the component on board 90, and outputs whether the component passes inspection, namely whether the component is mounted properly, to management device 19. Reflow oven 10e heats board 90 on which the component is mounted by component mounter 10c to melt the solder and execute a soldering operation. Function inspecting machine 10f performs a functional inspection of board 90 that has had soldering operation performed by reflow oven 10e. Specifically speaking, function inspecting machine 10f applies a predetermined input signal to board 90 and obtains an output signal for the input signal. Function inspecting machine 10f inspects whether the function of board 90 as a circuit is normal based on the output signal so obtained.

In this manner, board work line 10L conveys boards 90 sequentially and executes production operations including the inspecting operation to produce a board product by use of the multiple (six) work machines. A work machine or work machines can be added to board work line 10L as required according to types of board products to be produced, and thus, the configuration of board work line 10L can be changed as required. Board work line 10L can also include work machines including, for example, a buffer device, a board supply device, a board flipping device, a shield mounting device, an adhesive application device, an ultraviolet ray irradiation device, and the like.

The multiple (six) work machines making up board work line 10L and management device 19 are connected so as to communicate with each other. Management device 19 controls the multiple (six) work machines making up board work line 10L to thereby monitor an operating status of board work line 10L. Management device 19 stores various types of data for controlling the multiple (six) work machines. Management device 19 transmits the relevant data to the multiple (six) work machines. The multiple (six) work machines making up board work line 10L transmit the operating status and the production status of board work line 10L to management device 19.

### 1-2. Component Arrival Area 20

When at least one reel 22 arrives at component arrival area 20, a component management device (not shown) issues identification information that identifies reel 22. The identification information is stored in an identification medium such as a bar code, a wireless tag such as a radio frequency identifier (RFID), or the like. For the identification medium, for example, a two-dimensional bar code, a wireless tag, or the like may be used so as to store various types of information along with the identification information.

The component management device can read information such a bar code affixed to reel 22 by a supply source (a vendor). Then, the component management device can also obtain component information from a database (not shown) where information is registered on components housed in component tape 21 of reel 22. The component management device writes at least identification information of identification information and component information in the identification medium. In the present embodiment, the component management device writes both identification information and component information in the identification medium.

The operator attaches (for example, affixes) the identification medium which stores these pieces of information to reel 22. The work performed by the operator as described above can be automated using an actuator (for example, a robot arm or the like). On the other hand, at least part of the work that the component management device performs can also be performed by the operator. Reel 22 to which the identification medium is so attached is conveyed to reel storage container 30 by the operator or a conveyance device (not shown). The operator or the conveyance device can also carry or convey multiple reels 22 while being stored in a case or the like to reel storage container 30.

### 1-3. Reel Storage Container 30

Reel 22 which is loaded into reel storage container 30 will be referred to as first reel 22a. Component tape 21 wound around first reel 22a is rewound around second reel 22b as required. Second reel 22b has a reel diameter which differs from that of first reel 22a. The reel diameter of second reel 22b may be smaller than that of first reel 22a or larger than that of first reel 22a. In the present embodiment, the reel diameter of second reel 22b is smaller than that of first reel 22a. In addition, second reel 22b around which no component tape 21 is wound (an empty reel) and cassette 23 can be conveyed from component arrival area 20 as first reel 22a is done.

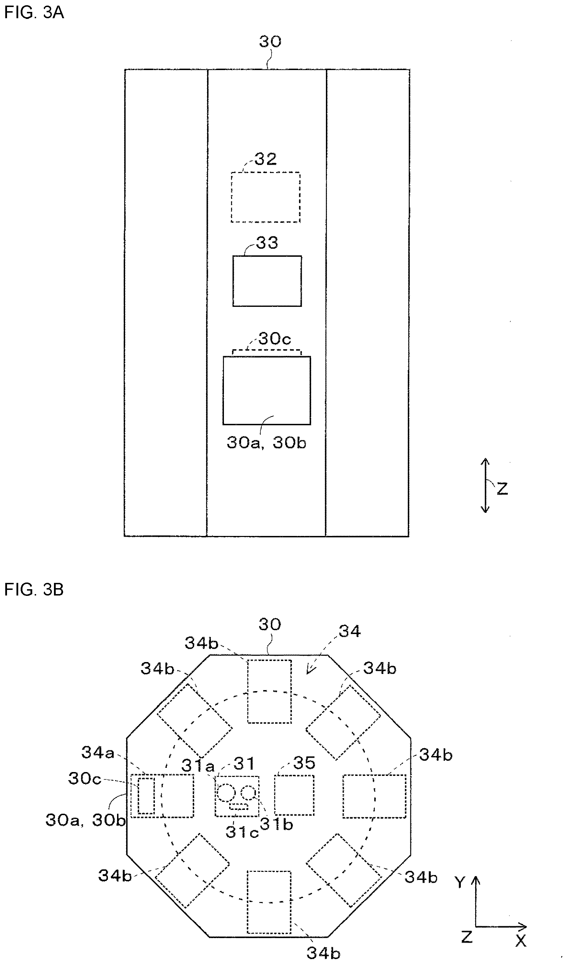

Reel storage container 30 stores reel 22 which is at least either of first reel 22a and second reel 22b. Reel storage container 30 can take various forms and shapes, provided that reel storage container 30 can store reel 22. As shown in Figs. 3a and 3b, in the present embodiment, reel storage container 30 has a shape of an octagonal prism. Additionally, reel storage container 30 includes entry port 30a, departure port 30b, reading device 30c, reel rewinding device 31, control device 32, display device 33, storage section34, and actuator 35. First reel 22a is loaded into reel storage container 30 from entry port 30a. Reel 22 is unloaded from departure port 30b. In the present embodiment, entry port 30a and departure port 30b are provided in an opening section common to both the ports. Entry port 30a and departure port 30b can also be provided in different opening sections. In addition, entry port 30a and departure port 30b are formed larger than reel 22 so that reel 22 can be conveyed in and out therethrough.

Reading device 30c is provided at entry port 30a of reel storage container 30. Reading device 30c reads the information stored in the identification medium attached to first reel 22a when first reel 22a is loaded into reel storage container 30. Reading device 30c can also be provided at departure port 30b of reel storage container 30. In this case, reading device 30c can read the information stored in the identification medium attached to reel 22 when reel 22 is unloaded from reel storage container 30. A well-known reading device (for example, a barcode reader for reading a barcode, a wireless reader for wirelessly communicating with a wireless or radio tag, and the like) can be used for reading device 30c.

In the present embodiment, entry port 30a and departure port 30b are provided in an opening section common to both the ports. Therefore, in the present embodiment, one reading device 30c is provided in the opening section. Specifically speaking, as shown in Figs. 3a and 3b, one reading device 30c is disposed above working space 34a lying close to the opening section, whereby one reading device 30c so disposed can read the information stored in the identification medium both when first reel 22a is loaded into reel storage container 30 for storage and when reel 22 is unloaded from reel storage container 30. Reel storage container 30 can also include multiple reading devices 30c.

Reel rewinding device 31 rewinds component tape 21 wound around first reel 22a around second reel 22b. A well-known rewinding device can be used for reel rewinding device 31. In the present embodiment, reel rewinding device 31 includes first resting section 31a, second resting section 31b, and counting section 31c. First reel 22a, around which component tape 21 is wound, is set on first resting section 31a. Second reel 22b (an empty reel), around which no component tape 21 is wound, is set on second resting section 31b. Reel rewinding device 31 feeds component tape 21 wound around first reel 22a to second reel 22b so as to rewind component tape 21 around second reel 22b. Counting section 31c is provided between first resting section 31a and second resting section 31b. When component tape 21 is fed out from first reel 22a to second reel 22b, counting section 31c can recognize components stored on component tape 21 so as to count the number of components (component number) stored on component tape 21.

Control device 32 includes a central processing device and a storage device, which are both generally known, to thereby make up a control circuit (neither of them is shown). The central processing unit is a central processing unit (CPU) and can perform various arithmetic processing operations. The storage device includes a first storage device and a second storage device. The first storage device is a volatile storage device, that is, a random access memory (RAM), and the second storage device is a non-volatile storage device, that is, a read only memory (ROM).

Control device 32 is connected with reading device 30c, reel rewinding device 31, display device 33, and actuator 35 in such a manner as to communicate therewith and can control these devices. Additionally, control device 32 is connected with management device 19 shown in Fig. 1 in such a manner as to communicate therewith. Management device 19 notifies control device 32 of an occurrence of setup changeover in component mounter 10c, an occurrence of shortage in reels 22 to be supplied to component mounter 10c, or an occurrence of a possibility of occurrence of setup changeover or shortage in reels 22. Control device 32, for example, causes reel 22 to be unloaded from reel storage container 30 based on the notification.

In addition, control device 32 can store reel information on reel 22 and can also notify management device 19 of the relevant reel information. The reel information can include a component type, a component quantity (the quantityof remaining components), an expiration data, a model type, and a vendor name of components stored on reel 22. Further, the reel information can also include a reel diameter, the quantity of reels, and the like of reel 22.

A well-known display device can be used for display device 33. Display device 33 displays various types of data so as to be visualized by the operator. Display device 33 displays, for example, the reel information described above or the like in response to an operation by the operator. In the present embodiment, display device 33 is made up of a touch panel. As a result, display device 33 also functions as an input device configured to accept various types of operations performed by the operator. For example, the operator can designate reel 22 to be unloaded from reel storage container 30 by use of the touch panel (display device 33 functioning as the input device). In this case, control device 32 causes reel 22 designated by the operator to be unloaded from reel storage container 30.

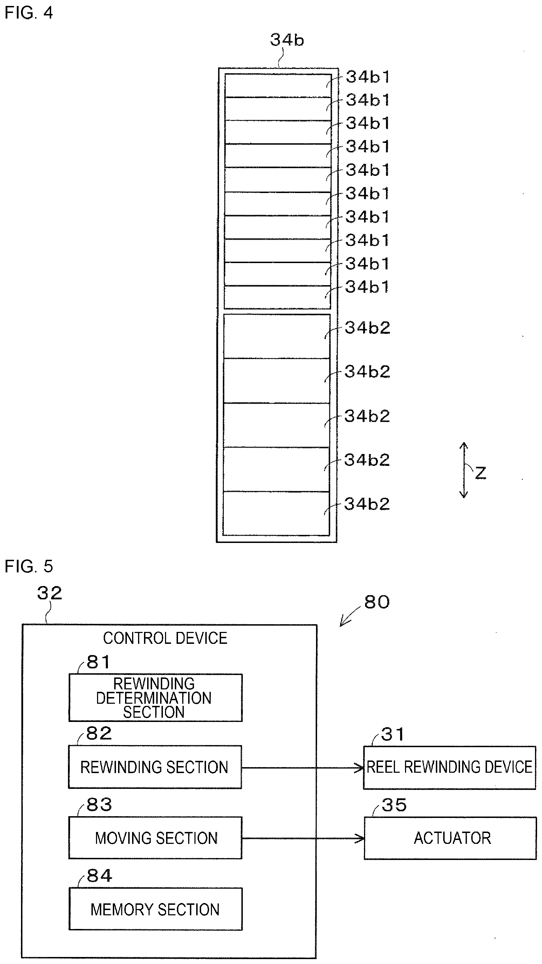

Storage section 34 can take various forms and shapes, provided that storage section 34 can store a storage object including reel 22. As shown in Fig. 3b, in the present embodiment, storage section 34 includes multiple (seven in the present embodiment) storage units 34b, and multiple (seven) storage units 34b are arranged into a circular shape (more accurately, an arc-like shape) as seen in a vertical direction (the Z-axis direction). As shown in Fig. 4, each of multiple (seven) storage units 34b includes multiple storage spaces 34b1, 34b2 each configured to store a storage object including reel 22, which are provided along the vertical direction (the Z-axis direction). In the present embodiment, storage unit 34b includes multiple types (for example, two types) of storage spaces 34b1, 34b2. Storage unit 34b can also include one type of storage space. In addition, the storage object may be stored in any storage unit 34b of multiple (seven) storage units 34b.

In the same figure, as a matter of convenience in illustration, multiple (10) storage spaces 34b1 and multiple (5) storage spaces 34b2 are illustrated. The numbers of storage spaces 34b1, 34b2 can be set as required. Reel 22 can be stored in any one of storage spaces 34b1, 34b2. The sizes (widths, depths, and heights) of storage spaces 34b1, 34b2 are set so as to match storage objects which are stored therein. For example, storage space 34b2 has a height dimension set larger than that of storage space 34b1, so as to store even a case. Such a case can store, for example, multiple reels 22 altogether. Incidentally, the vertical direction (the Z-axis direction) shown in Fig. 4 denotes a direction orthogonal to a horizontal plane defined by the X-axis direction and the Y-axis direction.

Actuator 35 moves a storage object. Actuator 35 is preferably provided radially inwards of multiple (seven) storage units 34b as seen in the vertical direction (the Z-axis direction). Actuator 35 can take various forms, provided actuator 35 can move a storage object. For example, a robot arm (an articulated robot), a raising and lowering slide mechanism, and the like can be used for actuator 35.

According to the present embodiment, reel storage container 30 includes storage section 34 and actuator 35. Storage section 34 includes multiple (seven) storage units 34b each including multiple storage spaces 34b1, 34b2 which are provided along the vertical direction (the Z-axis direction). Multiple (seven) storage units 34b are arranged into the circular shape as seen in the vertical direction (the Z-axis direction). In addition, actuator 35 is provided radially inwards of multiple (seven) storage units 34b as seen in the vertical direction (the Z-axis direction) and moves storage objects. As a result, with storage device 80 according to the present embodiment, even in the case that storage objects are stored in any storage unit 34b of multiple (seven) storage units 34b, a moving distance over which actuator 35 travels can be made generally uniform. Thus, with storage device 80 according to the present embodiment, when compared with, for example, a case in which multiple (seven) storage units 34b are provided rectilinearly, actuator 35 can be made small in size and simple in configuration.

1-4. Storage Device 80

To meet the necessity of rewinding component tape 21 around second reel 22b, storage device 80 causes component tape 21 wound around first reel 22a to be wound around second reel 22b. In addition, storage device 80 stores reel 22, which is at least either of first reel 22a and second reel 22b, in storage space 34b1, and unloads reel 22 so stored from storage space 34b1.

When regarding storage device 80 as a control block, storage device 80 includes rewinding section 82 and moving section 83. In addition, storage device 80 preferably includes at least either of rewinding determination section 81 and memory section 84. As shown in Fig. 5, in the present embodiment, storage device 80 includes rewinding determination section 81, rewinding section 82, moving section 83, and memory section 84. In the present embodiment, rewinding determination section 81, rewinding section 82, moving section 83, and memory section 84 are provided in control device 32 of reel storage container 30.

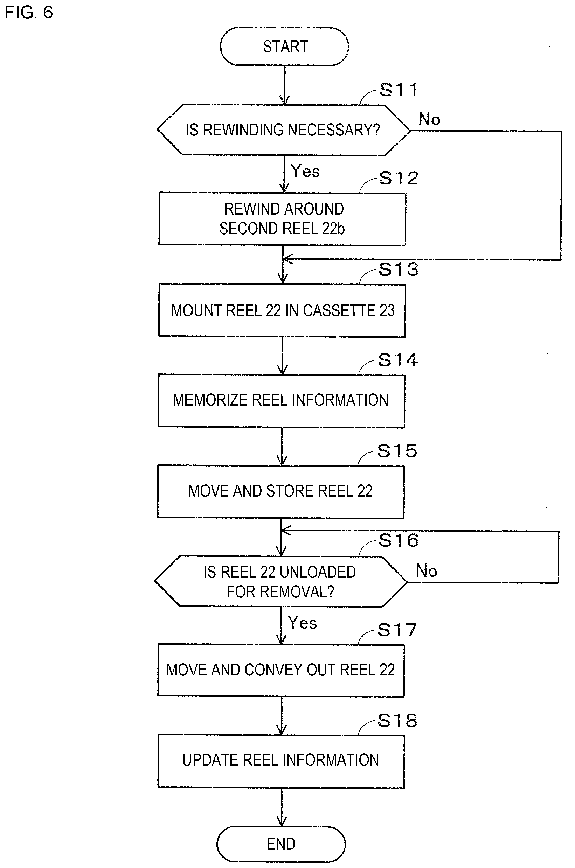

Storage device 80 executes a control in accordance with a flowchart shown in Fig. 6. Rewinding determination section 81 makes a determination shown in step S11. Rewinding section 82 executes a processing operation shown in step S12. Moving section 83 executes processing operations shown in steps S13, S15 and S17. In addition, moving section 83 executes a processing operation shown in step S16. Memory section 84 executes processing operations shown in steps S14 and S18.

### 1-4-1. Rewinding Determination Section 81

Rewinding determination section 81 determines that rewinding second reel 22b is necessary, when the reel diameter of first reel 22a differs from a reel diameter which enables first reel 22a to be set in feeder 24. As shown in Fig. 2c, in the present embodiment, reel 22 mounted in cassette 23 is set in feeder 24. Due to this, the reel diameter of reel 22 and cassette 23 are limited by feeder 24. Management device 19 manages combinations of reel 22, cassette 23, and feeder 24, as well as locations thereof. Rewinding determination section 81 can obtain these pieces of information from, for example, management device 19 to thereby obtain a reel diameter of reel 22 which enables reel 22 to be set in feeder 24 provided on component mounter 10c.

In addition, rewinding determination section 81 causes reading device 30c to read the identification information and the component information stored in the identification medium attached to first reel 22a when first reel 22a is loaded into reel storage container 30. Rewinding determination section 81 obtains the identification information and the component information of first reel 22a from reading device 30c. Rewinding determination section 81 determines whether a reel diameter included in the component information is a reel diameter obtained from management device 19 which enables first reel 22a to be set in feeder 24 (step 11 shown in Fig. 6).

If the reel diameter of first reel 22a differs from the reel diameter which enables first reel 22a to be set in feeder 24, rewinding determination section 81 determines that component tape 21 wound around first reel 22a needs to be rewound around second reel 22b (Yes in step S11). In this case, the control proceeds to step S12. If the reel diameter of first reel 22a is identical to the reel diameter which enables first reel 22a to be set in feeder 24, rewinding determination section 81 determines that rewinding component tape 21 around second reel 22b is unnecessary (No in step S11). In this case, the control proceeds to step S13.

### 1-4-2. Rewinding Section 82

As described above, when reel 22 mounted in cassette 23 is set in feeder 24, the reel diameter of reel 22 may be limited by feeder 24 from time to time. Additionally, even with a cassette-type feeder, the reel diameter of reel 22 may be limited from time to tome due to the demand for miniaturized reel 22. Since various reel diameters exist for reel 22, reel diameters need to be changed as required.

When first reel 22a is loaded into reel storage container 30 for storage, rewinding section 82 rewinds component tape 21 wound around first reel 22a around second reel 22b by use of reel rewinding device 31 in order to meet the necessity of rewinding component tape 21 around second reel 22b. In the present embodiment, when rewinding determination section 81 determines that component tape 21 needs to be rewound around second reel 22b, rewinding section 82 preferably causes component tape 21 wound around first reel 22a to be rewound around second reel 22b whose reel diameter enables second reel 22b to be set in feeder 24.

If rewinding determination section 81 determines that component tape 21 needs to be rewound around second reel 22b (Yes in step S11), rewinding section 82 causes component tape 21 wound around first reel 22a to be rewound around second reel 22b whose reel diameter enables second reel 22b to be set in feeder 24 (step S12). Specifically speaking, rewinding section 82 causes a gripping section (not shown) of actuator 35 to grip first reel 22a conveyed to working space 34a at entry port 30a so as to set first reel 22a so gripped on first resting section 31a of reel rewinding device 31. Additionally, rewinding section 82 causes the gripping section of actuator 35 to grip second reel 22b (an empty reel) around which component tape 21 is not wound so as to set second reel 22b on second resting section 31b of reel rewinding device 31.

Rewinding section 82 causes component tape 21 wound around first reel 22a to be wound around second reel 22b by use of reel rewinding device 31. Specifically speaking, reel rewinding device 31 feeds component tape 21 wound around first reel 22a to second reel 22b to rewind component tape 21 around second reel 22b. If the reel diameter of second reel 22b is smaller than the reel diameter of first reel 22a, there is a possibility that component tape 21 wound around first reel 22a is so long that a portion will remain unwound. In this case, rewinding section 82 causes a tape cutting device (not shown) to cut off the remaining portion of component tape 21. Additionally, rewinding section 82 causes the gripping section of actuator 35 to grip second reel 22b (an empty reel) around which component tape 21 is not wound so as to set second reel 22b on second resting section 31b of reel rewinding device 31. Rewinding unit 82 causes component tape 21 remaining on first reel 22a to be rewound around second reel 22b by use of reel rewinding device 31.

Since component tape 21 remaining on first reel 22a is rewound around second reel 22b, there is a possibility that remaining component tape 21 is not sufficient enough to be rewound around second reel 22b. In this case, rewinding section 82 causes the gripping section of actuator 35 to grip another first reel 22a so as to set it on first resting section 31a of reel rewinding device 31. In addition, rewinding section 82 causes component tapes 21 on first reel 22a and second reel 22b to be joined (spliced) together by use of a splicing device (not shown), so that a predetermined length of component tape 21 is wound around second reel 22b. Whether the predetermined length of component tape 21 is wound around second reel 22b can be determined based on, for example, a measurement value (component number) of counting section 31c of reel rewinding device 31.

Rewinding section 82 can cause component tape 21 wound around first reel 22a to be rewound around second reel 22b step by step by repeating the steps described above. What has been described above can also apply with a case in which the reel diameter of second reel 22b is larger than the reel diameter of first reel 22a. At least part of the operations that reel rewinding device 31, actuator 35, the splicing device, and the tape cutting device perform can also be performed by the operator.

According to the present embodiment, storage device 80 includes rewinding determination section 81 and rewinding section 82. Rewinding determination section 81 determines that rewinding second reel 22b is necessary when the reel diameter of first reel 22a differs from a reel diameter which enables first reel 22a to be set in feeder 24. When rewinding determination section 81 determines that component tape 21 needs to be rewound around second reel 22b, rewinding section 82 causes component tape 21 wound round first reel 22a to be rewound around second reel 22b whose reel diameter enables second reel 22b to be set in feeder 24. As a result, in the present embodiment, storage device 80 can cause component tape 21 wound around first reel 22a to be rewound around second reel 22b whose reel diameter enables second reel 22b to be set in feeder 24, when the reel diameter of first reel 22a differs from the reel diameter which enables first reel 22a to be set in feeder 24.

In the case that the reel diameter of reel 22 is limited due to, for example, a demand for miniaturization of reel 22, when the reel diameter of first reel 22a differs from a desired reel diameter, rewinding section 82 may cause component tape 21 wound around first reel 22a to be rewound around second reel 22b by use of reel winding device 31. Whether the reel diameter of first reel 22a is a desired reel diameter can be determined by reading device 30c obtaining the identification information and the component information of first reel 22a as rewinding determination section 81 does.

### 1-4-3. Moving Section 83

Moving section 83 moves reel 22 to predetermined storage space 34b1 for storage therein, and when reel 22 so stored is unloaded from storage space 34b1, moving section 83 moves reel 22 in question to departure port 30b of reel storage container 30 for unloading therefrom. In addition, moving section 83 preferably uses actuator 35 not only to move reel 22 to storage space 34b1 for storage therein but also to move out reel 22 so stored from storage space 34b1 to departure port 30b for unloading therefrom. Further, moving section 83 preferably uses actuator 35 to mount reel 22 in cassette 23.

When second reel 22b needs to be rewound with component tape 21, moving section 83 causes the gripping section of actuator 35 to grip second reel 22b which is rewound with component tape 21 and mount second reel 22 in question in cassette 23 (step S13). Moving section 83 causes the gripping section of actuator 35 to grip second reel 22b mounted in cassette 23 and move the second reel 22 in question to storage unit 34b including storage space 34b1 where the second reel 22 in question can be stored. Then, moving section 83 uses actuator 35 to store the second reel 22 in question in relevant storage space 34b1 (step S15). A processing operation shown in step S14 in Fig. 6 will be described below (1-4-4. Memory Section 84).

Next, moving section 83 determines whether second reel 22 is to be unloaded from reel storage container 30 (step S16). As has been described above, management device 19 notifies control device 32 of an occurrence of setup changeover in component mounter 10c, an occurrence of shortage in reels 22 to be supplied to component mounter 10c, or an occurrence of a possibility of occurrence of setup changeover or shortage in reels 22. Moving section 83 can cause the second reel 22 in question to be unloaded from reel storage container 30 based on, for example, the notification. When the operator designates the second reel 22b in question as reel 22 to be unloaded from reel storage container 30 using the touch panel (display device 33 functioning as an input device), moving section 83 can cause the second reel 22b in question to be unloaded from reel storage container 30.

If the second reel 22b in question is unloaded from reel storage container 30 (if Yes in step S16), moving section 83 causes the gripping section of actuator 35 to grip second reel 22b in question, which is now stored in storage space 34b1, and move the second reel 22b in question to working space 34a of departure port 30b, thereby allowing the second reel 22b in question to be conveyed out from reel storage container 30 (step S17). If the second reel 22b in question is not unloaded from reel storage container 30 (if No in step S16), the control returns to the determination shown in step S16. That is, moving section 83 waits until second reel 22b needs to be unloaded from reel storage container 30.

If rewinding component tape 21 around second reel 22b is unnecessary, moving section 83 causes the gripping section of actuator 35 to grip first reel 22a, which is conveyed to working space 34a of entry port 30a, and mount the first reel 22a in question in cassette 23 (step S13). Moving section 83 causes the gripping section of actuator 35 to grip first reel 22a mounted in cassette 23 and move the first reel 22a in question to storage unit 34b including storage space 34b1 where the first reel 22a in question can be stored. Then, moving section 83 uses actuator 35 to store the first reel 22a in question in relevant storage space 34b1 (step S15). In this way, in the case that rewinding second reel 22b with component tape 21 is unnecessary, the description is the same as that of the case in which rewinding second reel 22b with component tape 21 is necessary, just with "second reel 22b" being read as "first reel 22a".

According to the present embodiment, moving section 83 uses actuator 35 not only to move reel 22 to storage space 34b1 for storage therein but also to move reel 22 from storage space 34b1 to departure port 30b from reel storage container 30. As a result, with storage device 80 of the present embodiment, an automated loading and unloading of reel 22 can be achieved. As described above, reel storage container 30 include storage section 34 and actuator 35. As a result, with storage device 80 of the present embodiment, the automated loading and unloading of reel 22 can be achieved with miniaturizing the size and simplification in structure of actuator 35. Further, moving section 83 uses actuator 35 to mount reel 22 in cassette 23. As a result, with storage device 80 of the present embodiment, mounting reel 22 in cassette 23 can be automated.

1-4-4. Memory Section 84

Memory section 84 memorizes at least one of a component type, a component quantity, and an expiration date of components stored in component tape 21 wound around reel 22, as well as reel diameters and reel quantities of reels 22. These pieces of information on reels 22 are included in the reel information that has already been described above. In addition to the pieces of information described above, memory section 84 can also memorize model types of components stored on component tapes 21 of reels 22, vendor names, and the like. Additionally, memory section 84 can also memorize information on cassette 23 mounted on reel 22 (cassette information). The cassette information includes, for example, identification information by which cassettes 23 are identified, model types, information on reels 22 and feeders 24 which can be used together with cassettes 23, and the like. At least part of the reel information and the cassette information can also be memorized by management device 19. In this way, memory section 84 can be provided in at least either of reel storage container 30 and management device 19.

As has been described above, control device 32 of reel storage container 30 includes a non-volatile second memory device (not shown). For the second memory device, a memory device can be used which can rewrite memorized data including, for example, flash memory, electrically erasable programmable read only memory (EEPROM), and the like. Additionally, for example, a magnetic memory device such as a hard disk drive (HDD), an optical memory device such as an optical disk, and the like can also be used for the second memory device.

If rewinding second reel 22b with component tape 21 is necessary, memory section 84 memorizes at least one of a component type, a component number, and an expiration date of components stored on component tape 21 rewound around second reel 22b, as well as a reel diameter and a reel quantity of second reel 22b at the second memory device (step S14). In addition, control device 32 causes the identification medium attached to second reel 22b to memorize these pieces of information. In this case, the component number, the reel diameter, and the reel quantity are varied from those resulting at the time of loading into reel storage container 30 in association with rewinding component tape 21.

If rewinding second reel 22b with component tape 21 is unnecessary, memory section 84 memorizes at least one of a component type, a component number, and an expiration date of components stored in component tape 21 wound around first reel 22a, as well as a reel diameter and a reel quantity of first reel 22a at the second memory device (step S14). In this case, since rewinding component tape 21 around second reel 22b is not performed, these pieces of information do not change from those at the time of loading into reel storage container 30. Thus, rewriting the information in the identification medium attached to first reel 22a is unnecessary.

In this way, memory section 84 can memorize the reel information on reel 22 at the second memory device. Additionally, memory section 84 updates the reel information (for example, the reel quantity of reels 22) when reel 22 is unloaded from reel storage container 30 (step S18). Further, memory section 84 can notify management device 19 of the reel information. What has been described above about the reel information can be said true also with the cassette information.

According to the present embodiment, memory section 84 memorizes at least one of a component type, component quantity, and expiration date of components stored in component tape 21 wound around reel 22, as well as a reel diameter and a reel quantity of reel 22. As a result, storage device 80 of the present embodiment can memorize the reel information on reel 22 (at least either of first reel 22a and second reel 22b).

Memory section 84 may memorize further at least one of positional information, loading and unloading information, and storage information. The positional information indicates a storage location of reel 22. The loading and unloading information indicates the loading date and time and the unloading date and time of reel 22. The storage information indicates at least either of an ambient temperature and humidity within reel storage container 30. In the present embodiment, memory section 84 memorizes the positional information, the loading and unloading information, and the storage information (the ambient temperature and humidity within reel storage container 30) at the second memory device. Specifically speaking, memory section 84 memorizes the positional information and the loading date and time of reel 22 in the second memory device when storing reel 22. Memory section 84 memorizes the storage information in the second memory device during storage of reel 22. Memory section 84 memorizes the unloading date and time of reel 22 in the second memory device at the timing of unloading of reel 22.

### 2. Second Embodiment

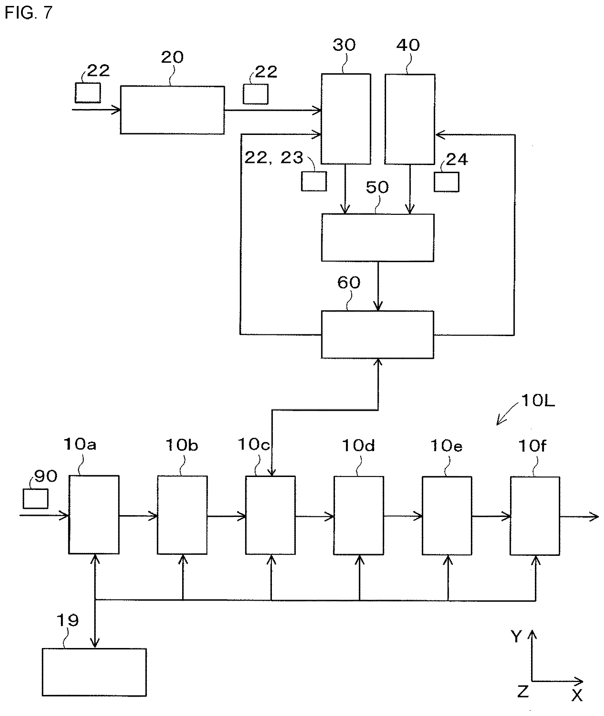

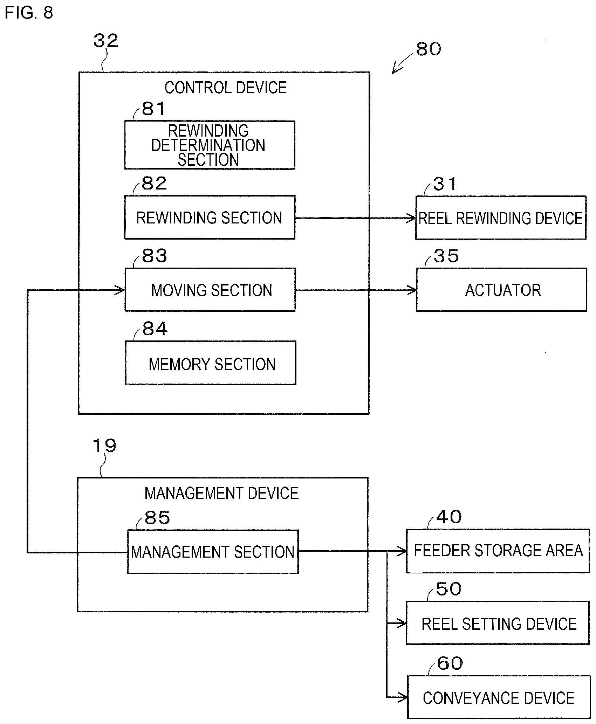

As shown in Fig. 7, a second embodiment differs from the first embodiment in that feeder storage container 40, reel setting device 50, and conveyance device 60 are further provided in the second embodiment. In addition, as shown in Fig. 8, the second embodiment differs from the first embodiment in that storage device 80 further includes management section 85.

### 2-1. Feeder Storage Container 40, Reel Setting Device 50, and Conveyance Device 60

Feeder storage container 40 stores feeder 24. Feeder storage container 40 can take various forms and shapes, as long as feeder storage container 40 can store feeder 24. Feeder storage container 40 can allow feeder 24 to be loaded therein one by one at the timing of loading, and can allow feeder 24 to be unloaded one by one at the timing of unloading. Alternatively, feeder storage container 40 can also allow multiple feeders 24 to be loaded therein altogether at the timing of loading, and can also allow multiple feeders 24 to be unloaded therefrom altogether at the timing of unloading with using, for example, a feeder pallet (not shown) designed to store multiple feeders 24. Further, as with reel storage container 30, feeder storage container 40 can move feeder 24 into a storage space for storage therein, and move feeder 24 from the storage space to a departure port for unloading therefrom, with using an actuator. In this case, with feeder storage container 40, the loading and unloading of feeder 24 can be automated.

Reel setting device 50 performs at least part of an operation of setting reel 22 in feeder 24 in an automated fashion. Also, in the present embodiment, cassette 23 is preferably mounted on reel 22. As has been described before, a leading end portion of component tape 21 is pulled out to component pickup section 24c shown in Fig. 2, whereby components are supplied sequentially. Reel setting device 50 stores reel 22 mounted in cassette 23 in such a manner as to correspond to storage section 24a1 formed in main body section 24a of feeder 24 shown in Fig. 2b. For example, an actuator (not shown) including a gripping section can be used to store reel 22.

Further, reel setting device 50 feeds out component tape 21 to component pickup section 24c. Sprocket 24b shown in Fig. 2b and a driving device (not shown) therefor can be used to feed out component tape 21. A tape feeding mechanism (not shown) provided in reel setting device 50 can also be used to feed out component tape 21. Furthermore, reel setting device 50 peels off a cover tape from component tape 21 immediately before component pickup section 24c. A peel-off mechanism (not shown) provided in reel setting device 50 can be used to peel off the cover tape. Reel setting device 50 performs at least part of these operations in an automated fashion. Operations that are not automated can be performed by the operator. Reel setting device 50 can also collate identification information of reel 22 set in feeder 24 and feeder 24.

Conveyance device 60 conveys at least either of reel 22 and feeder 24 to component mounter 10c. When conveying reel 22, conveyance device 60 conveys reel 22 from reel storage container 30 to component mounter 10c. When conveying feeder 24, conveyance device 60 conveys feeder 24 from feeder storage container 40 to component mounter 10c. When conveying reel 22 and feeder 24 set by reel setting device 50, conveyance device 60 conveys reel 22 and feeder 24 from reel setting device 50 to component mounter 10c.

In addition, conveyance device 60 returns reel 22 from component mounter 10c to reel storage container 30. Reel 22 so returned includes components which were not used in component mounter 10c. Further, conveyance device 60 returns feeder 24 from component mounter 10c to feeder storage container 40. Feeder 24 so returned is at least either of feeder 24 in which reel 22 is set which includes components which were not used in component mounter 10c and feeder 24 in which reel 22 was set after relevant reel 22 was used up in component mounter 10c. Conveyance device 60 can take various forms, provided that conveyance device 60 can convey the conveyance objects described above. For example, an automatic guided vehicle (AGV) can be used for conveyance device 60.

### 2-2. Management Section 85

In the present embodiment, when regarding storage device 80 as a control block, as shown in Fig. 8, storage device 80 includes rewinding determination section 81, rewinding section 82, moving section 83, memory section 84, and management section 85. In the present embodiment, rewinding determination section 81, rewinding section 82, moving section 83, and memory section 84 are provided in control device 32 of reel storage container 30. Management section 85 is provided in a control device (not shown) of management device 19. Management section 85 manages the production of component mounter 10c.

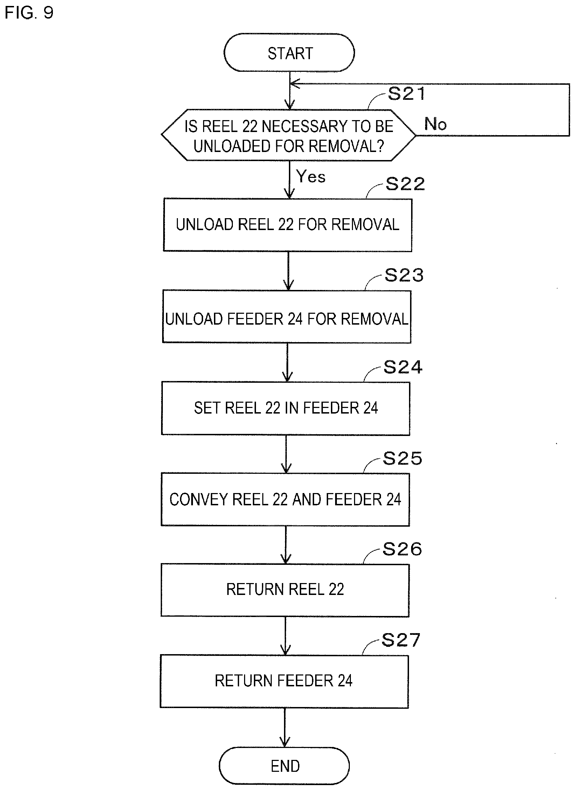

Management section 85 can manage the production of component mounter 10c by performing control in accordance with, for example, a flowchart shown in Fig. 9. Specifically speaking, management section 85 determines whether reel 22 needs to be unloaded from reel storage container 30 (step S21). Management section 85 can make the determination described above based on, for example, whether a setup changeover occurs in component mounter 10c, whether a shortage occurs in components to be supplied to component mounter 10c, or whether there occurs a possibility that a setup changeover or a shortage in components to be supplied occurs.

Management section 85 causes reel 22 to be unloaded from reel storage container 30 using moving section 83 upon occurrence of a setup changeover in component mounter 10c, occurrence of a shortage in components to be supplied to component mounter 10c, or occurrence of a possibility that a setup changeover or a shortage in components occurs (if Yes in step S21) (step S22). Control device 32 of reel storage container 30 and management device 19 are connected in such a manner as to communicate with each other. If the condition described above is established, management section 85 instructs reel storage container 30 to unload reel 22. If the condition described above is not established, (if No in step S21), the control returns to the determination shown in step S21. In this case, management section 85 waits until the condition is established.

Next, management section 85 causes feeder storage container 40 to unload feeder 24 therefrom according to the number of reels 22 unloaded from reel storage container 30 (step S23). A control device (not shown) of feeder storage container 40 and management device 19 are connected in such a manner as to communicate with each other. Upon instructing reel storage container 30 to unload reel 22 therefrom, management section 85 instructs then feeder storage container 40 to unload feeder 24 therefrom according to the number of reels 22 unloaded from reel storage container 30.

Management section 85 causes reel setting device 50 to set reel 22 in feeder 24 (step S24). A control device (not shown) of reel setting device 50 and management device 19 are connected in such a manner as to communicate with each other. When reel 22 is unloaded from reel storage container 30, reel storage container 30 notifies management device 19 of the completion of unloading of reel 22. When feeder 24 is unloaded from feeder storage container 40, feeder storage container 40 notifies management device 19 of the completion of unloading of feeder 24 therefrom. When the completion of unloading of reel 22 and feeder 24 is notified, management section 85 instructs reel setting device 50 to set reel 22 and feeder 24.

Further, management section 85 causes conveyance device 60 to convey reel 22 and feeder 24 to component mounter 10c (step S25). In the present embodiment, conveyance device 60 is an automatic guided vehicle (AGV), and conveyance device 60 and management device 19 are connected in such a manner as to communicate wirelessly with each other. When reel 22 and feeder 24 are set completely, reel setting device 50 notifies management device 19 of the complete setting of reel 22 and feeder 24. When the complete setting of reel 22 and feeder 24 is notified, management section 85 instructs conveyance device 60 to convey reel 22 and feeder 24 which are so set.

Management section 85 can also cause conveyance device 60 to convey only reel 22. In this case, the operator carries feeder 24 from feeder storage container 40 to component mounter 10c. In addition, management section 85 can also cause conveyance device 60 to convey only feeder 24. In this case, the operator carries reel 22 from reel storage container 30 to component mounter 10c. Further, in such a state that reel 22 is not set in feeder 24, management section 85 can also cause conveyance device 60 to convey reel 22 from reel storage container 30 to component mounter 10c and convey feeder 24 from feeder storage container 40 to component mounter 10c. In this way, management section 85 can cause conveyance device 60 to convey at least either of reel 22 and feeder 24 to component mounter 10c.

Additionally, as in the case of conveying reel 22 to component mounter 10c, management section 85 causes conveyance device 60 to return reel 22 to reel storage container 30 (step S26). Reel 22 so returned includes components which are not used in component mounter 10c. Further, management section 85 causes conveyance device 60 to return feeder 24 to feeder storage container 40 (step S27). Feeder 24 so returned is at least either of feeder 24 in which reel 22 is set which includes components which were not used in component mounter 10c and feeder 24 in which reel 22 was set after relevant reel 22 is used up in component mounter 10c. The operator can also perform at least part of the processing operations from step S23 to step S27.

Management section 85 preferably manages combinations of reel 22, cassette 23, and feeder 24 and locations thereof in association with each other. As has been described above, management device 19 can communicate with reel storage container 30, feeder storage container 40, reel setting device 50, and conveyance device 60. In addition, in the present embodiment, memory section 84 memorizes at least one of a component type, a component number, and an expiration date of components stored on component tape 21 wound around reel 22, as well as a reel diameter and reel quantity of reel 22. Further, in the present embodiment, memory section 84 memorizes information on cassette 23 mounted on reel 22 (cassette information).

Management section 85 communicates with reel storage container 30, feeder storage container 40, reel setting device 50, and conveyance device 60 to thereby obtain combinations of reel 22, cassette 23, and feeder 24 and locations thereof. Management section 85 can obtain these pieces of information individually in steps S22 to S27. Management device 19 includes a non-volatile memory device (not shown) similar to control device 32 of reel storage container 30. Management section 85 can memorize the information so obtained in the memory device described above. The information obtained can be memorized in association with one another using, for example, a correlation table.

According to the present embodiment, management section 85 causes moving section 83 to unload reel 22 from reel storage container 30 upon an occurrence of a setup changeover in component mounter 10c, an occurrence of a shortage in components to be supplied to component mounter 10c, or an occurrence of a possibility of occurrence of a setup changeover or a shortage in components. As a result, with storage device 80 of the present embodiment, reel 22 can be unloaded from reel storage container 30 in association with a setup changeover in component mounter 10c. Additionally, with storage device 80, reel 22 can be unloaded from reel storage container 30 in association with a shortage in components to be supplied to component mounter 10c.

Further, management section 85 can cause feeder storage container 40 where to store feeder 24 to unload feeder 24 therefrom according to the number of reels 22 unloaded from reel storage container 30. As a result, with storage device 80 of the present embodiment, feeder 24 can be unloaded in such a manner as to match the number of reels 22 unloaded from reel storage container 30. Management section 85 causes reel setting device 50 to set reel 22 in feeder 24. As a result, with storage device 80 of the present embodiment, at least part of the operation of setting reel 22 in feeder 24 can be automated. Further, management section 85 causes conveyance device 60 to convey at least either of reel 22 and feeder 24 to component mounter 10c. As a result, with storage device 80 of the present embodiment, the conveyance of at least either of reel 22 and feeder 24 can be automated.

Management section 85 causes conveyance device 60 to return reel 22 including components that are not used in component mounter 10c to reel storage container 30. As a result, with storage device 80 of the present embodiment, when reel 22 is unnecessary, the return of reel 22 in question can be automated. Further, management section 85 causes conveyance device 60 to return at least either of feeder 24 in which reel 22 is set which includes components which are not used in component mounter 10c and feeder 24 in which reel 22 was set after reel 22 in question has been used in component mounter 10c to feeder storage container 40. As a result, with storage device 80 of the present embodiment, when feeder 24 is unnecessary, the return of feeder 24 can be automated. Management section 85 manages combinations of reel 22, cassette 23, and feeder 24 and locations thereof in association with each other. As a result, with storage device 80 of the present embodiment, combinations of reel 22, cassette 23, and feeder 24 and locations thereof can easily be obtained, thereby the management thereof being made easy.

### 2-3. Arrangement Example

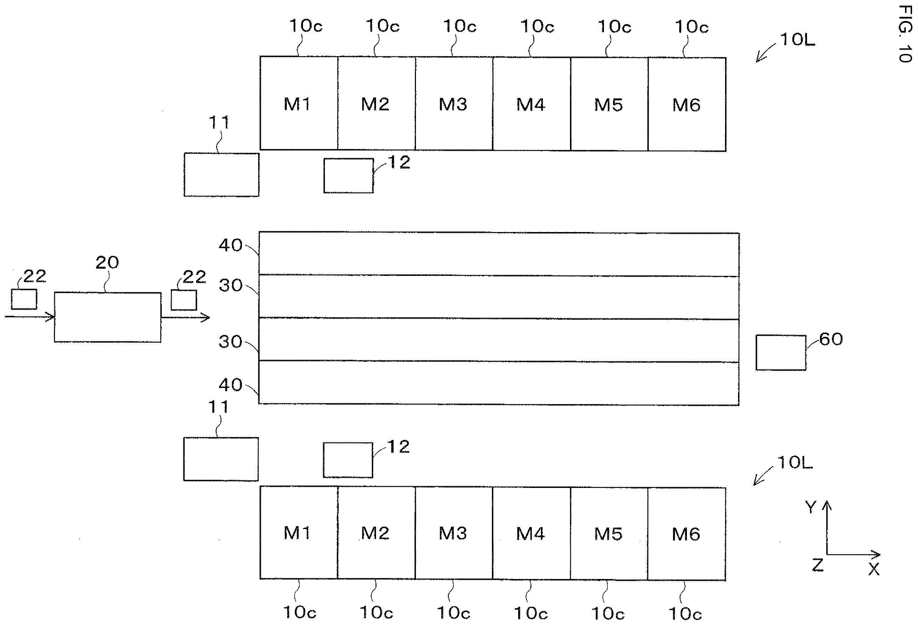

Fig. 10 shows an arrangement example of board work lines 10L, reel storage containers 30, and feeder storage containers 40. As shown in the figure, two reel storage containers 30 and two feeder storage containers 40 are provided between two board work lines 10L. In Fig. 10, in each of two board work lines 10L, printer 10a, print inspecting machine 10b, external appearance inspecting machine 10d, reflow oven 10e, and function inspecting machine 10f are omitted from illustration. In addition, each of two board work lines 10L includes multiple (six) component mounters 10c, and identification numbers M1 to M6 are assigned individually to multiple (six) component mounters 10c.

First reel storage container 30 of two reel storage containers 30 and first feeder storage container 40 of two feeder storage containers 40 are arranged so that an opening section (corresponding to entry port 30a and departure port 30b) of first reel storage container 30 and an opening section (corresponding to an entry port and a departure port) of first feeder storage 40 face each other. In Fig. 10, although the arrangement of the reel storage containers and the feeder storage containers is schematically shown, a working space, where reels 22 and feeders 24 are loaded and unloaded from the storage containers, is provided between relevant reel storage container 30 and relevant feeder storage container 40. Additionally, reel setting device 50 can also be disposed between relevant reel storage container 30 and relevant feeder storage container 40, and conveyance device 60 can also be caused to travel therebetween for conveyance of reels and feeders. What has been described above applies for second reel storage container 30 of two reel storage containers 30 and second feeder storage container 40 of two feeder storage containers 40.

Preparation area 11 is provided in the vicinity of leading component mounter 10c (component mounter 10c having identification number M1) of each of two board work lines 10L. A monitoring device (not shown), which can communicate with management device 19, is provided in preparation area 11. For example, when reel 22 and feeder 24 are conveyed to preparation area 11 by conveyance device 60, the operator can collate the identification information of reel 22 with that of feeder 24 by use of the monitoring device. In addition, the operator can set reel 22 in feeder 24 in preparation area 11. In the case that the identification information is collated by reel setting device 50, the collating operation in preparation area 11 can be omitted. In the case that reel 22 is set in feeder 24 by reel setting device 50, the setting operation in preparation area 11 becomes unnecessary.

A temporary storage device (not shown) is provided in preparation area 11. The temporary storage device has multiple slots, so that feeder 24 in which reel 22 is set can be set in one slot for temporary storage. Once feeder 24 is set in a slot, feeder 24 can communicate with the monitoring device. As a result, the monitoring device records the slot of the temporary storage device and the identification information of feeder 24 set in the relevant slot in an associated fashion.

Exchanging device 12 is provided for each of two board work lines 10L. Exchanging device 12 can be moved along a direction (the X-axis direction) in which multiple (six) component mounters 10c are aligned by a moving mechanism (not shown). Exchanging device 12 can supply, for example, feeder 24 temporarily stored in the temporary storage device in preparation area 11 to desired component mounter 10c. Additionally, exchanging device 12 can regain, for example, feeder 24 that has been used up from component mounter 10c. Feeder 24, which is used up and so regained, is returned from preparation area 11 to feeder storage container 40 by conveyance device 60. In the case that reel 22 including components that are not used in component mounter 10c exists, relevant reel 22 is returned from preparation area 11 to reel storage container 30 by conveyance device 60.

According to the present embodiment, reel storage containers 30 and feeder storage containers 40 are provided between two board work lines 10L. As a result, with storage device 80 of the present embodiment, traveling distances over which conveyance device 60 travels between two board work lines 10L can be made equal. Consequently, with storage device 80 of the present embodiment, the conveyance efficiency of conveyance device 60 can be improved.

### 2-4. Others

In the present embodiment, storage device 80 includes rewinding determination section 81, rewinding section 82, moving section 83, memory section 84, and management section 85. However, at least one of rewinding determination section 81, rewinding section 82, moving section 83, and memory section 84 can be omitted. In the case of rewinding determination section 81 and rewinding section 82 being omitted, reel rewinding device 31 can be omitted. Further, in the present embodiment, although memory section 84 is provided in control device 32 of reel storage container 30, memory section 84 can also be provided in management device 19.

### 3. Reel Storage Method

What has been described for storage device 80 also applies to a reel storage method. Specifically speaking, the reel storage method is applied to storage device 80 including reel storage container 30, reel rewinding device 31, and storage spaces 34b1, 34b2. The control performed by rewinding determination section 81 corresponds to a rewinding determination step. The control performed by rewinding section 82 corresponds to a rewinding step. The control performed by moving section 83 corresponds to a moving step. The control performed by memory section 84 corresponds to a memorizing step. The control performed by management section 85 corresponds to a management step Also, in the reel storage method, the same working effects as the working effects obtained by storage device 80 can be obtained.

### 4. Example of Working Effect of the Embodiments

Storage device 80 includes reel storage container 30, reel rewinding device 31, storage spaces 34b1, 34b2, rewinding section 82, and moving section 83. As a result, upon determining on the necessity of rewinding component tape 21 around second reel 22b, storage device 80 can rewind component tape 21, which is wound around first reel 22a, around second reel 22b. In addition, storage device 80 can store reel 22, which is at least either of first reel 22a and second reel 22b, in storage space 34b1, and when reel 22 is unloaded from reel storage container 30, storage device 80 can bring out relevant reel 22 from relevant storage space 34b1. What has been described for storage device 80 also applies to the reel storage method.

### Reference Signs List

10c: Component mounter, 21: Component tape, 22: Reel, 22a: First reel, 22b: Second reel, 23: Cassette, 24: Feeder, 30: Reel storage container, 30b: Departure port, 31: Reel rewinding device, 34: Storage section,34b: Storage unit, 34b1, 34b2: Storage space, 35: Actuator, 40: Feeder storage container, 50: Reel setting device, 60: Conveyance device, 80: Storage device, 81: Rewinding determination section, 82: Rewinding section, 83: Moving section,84: Memory section,85: Management section, 90: Board.

## Claims

1. A storage device (80) comprising:
a reel storage container (30) configured to store a first reel (22a) around which a component tape (21) with packaging components therein is wound and a second reel (22b) having a different reel diameter from that of the first reel (22a);
a reel rewinding device (31) provided in the reel storage container (30);
a storage space (34b1, 34b2) provided in the reel storage container (30) to store a storage object including the reel (22);
a rewinding section (82) configured to cause the component tape (21) wound around the first reel (22a) to be rewound around the second reel (22b) by use of the reel rewinding device (31) in a case of it being necessary to rewind the component tape (21) around the second reel (22b) when the first reel (22a) is loaded into the reel storage container (30); and
a moving section (83) configured to move the reel (22) to the predetermined storage space (34b1, 34b2) to be stored therein and move the reel (22) stored in the storage space (34b1, 34b2) to a departure port (30b) of the reel storage container (30) to be unloaded therefrom when the reel (22) is to be unloaded from the reel storage container (30).

2. The storage device (80) according to claim 1, wherein the storage device (80) further comprises a rewinding determination section (81) configured to determine that it is necessary to rewind the component tape (21) around the second reel (22b) when a reel diameter of the first reel (22a) differs from a reel diameter that enables the first reel (22a) to be set in a feeder (24), and
wherein, when rewinding the component tape (21) around the second reel (22b) is determined to be necessary by the rewinding determination section (81), the rewinding section (82) causes the component tape (21) wound around the first reel (22a) to be rewound around the second reel (22b) whose reel diameter enables the second reel (22b) to be set in the feeder (24).

3. The storage device according to claim 1 or 2, wherein the reel storage container (30) comprises a storage section (34) including multiple storage units (34b) in each of which multiple of the storage spaces (34b1, 34b2) are provided along a vertical direction, the multiple storage units (34b) being arranged into a circular shape as seen in the vertical direction;
wherein an actuator (35) is provided inwards of the multiple storage units (34b) as seen in the vertical direction, the actuator (35) being configured to move the storage object, and
wherein the moving section (83) causes the actuator (35) to move the reel (22) to the storage space (34b1, 34b2) to be stored therein and move the reel (22) from the storage space (34b1, 34b2) to the departure port (30b) to be unloaded from the reel storage container (30).

4. The storage device (80) according to any one of claims 1 to 3, wherein the storage device (80) has a memory section (84) configured to memorize at least one of a component type, a component number, and an expiration date of the components stored on the component tape (21) wound around the reel (22), as well as a reel diameter and reel quantity of the reel (22).

5. The storage device (80) according to any one of claims 1 to 4, wherein the storage device (80) further comprises a management section (85) configured to manage a production of a component mounter (10c) configured to pick up the component supplied from a feeder (24) in which the reel (22) is detachably set and mount the component on a board (90), and wherein the management section (85) causes the reel (22) to be unloaded from the reel storage container (30) by use of the moving section (83) upon occurrence of a setup changeover in the component mounter (10c), occurrence of a shortage in the components supplied to the component mounter (10c), or occurrence of a possibility of occurrence of the setup changeover or the shortage in the components.

6. The storage device (80) according to claim 5, wherein the management section (85) causes a feeder storage container (40) where the feeder (24) is stored to unload the feeder (24) therefrom in accordance with a quantity of the reels (22) unloaded from the reel storage container (30).

7. The storage device (80) according to claim 5 or 6, wherein the management section (85) causes the reel (22) to be set in the feeder (24) by use of a reel setting device (50) configured to perform at least part of an operation of setting the reel (22) in the feeder (24) in an automated manner.

8. The storage device (80) according to any one of claims 5 to 7, wherein the management section (85) uses a conveyance device (60) to convey at least either of the reel (22) and the feeder (24) to the component mounter (10c).

9. The storage device (80) according to claim 5, wherein the management section (85) causes the reel (22) including the components which were not used in the component mounter (10c) to return to the reel storage container (30) by use of conveyance device (60).

10. The storage device (80) according to claim 5, wherein the management section (85) causes at least either of the feeder (24) in which the reel (22) including the components which were not used in the component mounter (10c) is set and the feeder (24) in which the reel (22) was set after the reel (22) is used in the component mounter (10c) to return to a feeder storage container (40) where the feeder (24) is stored by use of a conveyance device (60).

11. The storage device (80) according to any one of claims 5 to 10,
wherein the storage object is a cassette (23) including the reel (22) and the reel (22) is mounted detachably in the cassette (23), and
wherein the management section (85) manages combinations of the reel (22), the cassette (23), and the feeder (24) and locations thereof in association with each other.

12. A reel storage method for a storage device (80) comprising:
a reel storage container (30) configured to store a first reel (22a) around which a component tape (21) with packaging components therein is wound and a second reel (22b) having a different reel diameter from that of the first reel (22a);
a reel rewinding device (31) provided in the reel storage container (30); and
a storage space (34b1, 34b2) provided in the reel storage container (30) to store a storage object including the reel (22), the reel storage method comprising:
a rewinding step of causing the component tape (21) wound around the first reel (22a) to be rewound around the second reel (22b) by use of the reel rewinding device (31) in a case of it being determined that it is necessary to rewind the component tape (21) around the second reel (22b) when the first reel (22a) is loaded into the reel storage container (30) to be stored therein; and
a moving step of moving the reel (22) to the predetermined storage space (34b1, 34b2) to be stored therein and move the reel (22) stored in the storage space (34b1, 34b2) to a departure port (30b) of the reel storage container (30) to be unloaded therefrom when the reel (22) is to be unloaded from the reel storage container (30).

## Patentansprüche

1. Eine Speichervorrichtung (80), umfassend:
einen Spulenspeicherbehälter (30), der konfiguriert ist, um eine erste Spule (22a), um die ein Komponentenband (21) mit Verpackungskomponenten gewickelt ist, und eine zweite Spule (22b) mit einem anderen Spulendurchmesser als die erste Spule (22a) zu speichern;
eine Spulenumspulvorrichtung (31), die im Spulenspeicherbehälter (30) vorgesehen ist;
einen Speicherplatz (34b1, 34b2), der im Spulenspeicherbehälter (30) vorgesehen ist, um einen Speichergegenstand einschließlich der Spule (22) zu speichern;
einen Umspulabschnitt (82), der konfiguriert ist, um zu bewirken, dass das um die erste Spule (22a) gewickelte Komponentenband (21) unter Verwendung der Spulenumspulvorrichtung (31) um die zweite Spule (22b) aufgewickelt wird, wenn es erforderlich ist, das Komponentenband (21) um die zweite Spule (22b) aufzuwickeln, wenn die erste Spule (22a) in den Spulenspeicherbehälter (30) geladen wird; und
einen Bewegungsabschnitt (83), der konfiguriert ist, um die Spule (22) zum vorbestimmten Speicherplatz (34b1, 34b2) zu bewegen, um dort gespeichert zu werden, und die Spule (22), die im Speicherplatz (34b1, 34b2) gespeichert ist, zu einer Ausgangsöffnung (30b) des Spulenspeicherbehälters (30) zu bewegen, um daraus entladen zu werden, wenn die Spule (22) aus dem Spulenspeicherbehälter (30) entladen werden soll.

2. Speichervorrichtung (80) nach Anspruch 1, wobei die Speichervorrichtung (80) außerdem einen Umspulbestimmungsabschnitt (81) umfasst, der konfiguriert ist, um zu bestimmen, dass es notwendig ist, das Komponentenband (21) um die zweite Spule (22b) aufzuwickeln, wenn ein Spulendurchmesser der ersten Spule (22a) von einem Spulendurchmesser abweicht, der es ermöglicht, die erste Spule (22a) in eine Zuführvorrichtung (24) einzusetzen, und
wobei, wenn durch den Umspulbestimmungsabschnitt (81) festgestellt wird, dass ein Aufwickeln des Komponentenbands (21) um die zweite Spule (22b) erforderlich ist, der Umspulabschnitt (82) bewirkt, dass das Komponentenband (21), das um die erste Spule (22a) gewickelt ist, um die zweite Spule (22b), deren Spulendurchmesser es ermöglicht, die zweite Spule (22b) in die Zuführvorrichtung (24) einzusetzen, aufgewickelt wird.

3. Speichervorrichtung nach Anspruch 1 oder 2, wobei der Spulenspeicherbehälter (30) einen Speicherbereich (34) mit mehreren Speichereinheiten (34b) umfasst, in denen jeweils entlang einer vertikalen Richtung mehrere Speicherplätze (34b1, 34b2) vorgesehen sind, wobei die mehreren Speichereinheiten (34b) in vertikaler Richtung gesehen kreisförmig angeordnet sind;
wobei ein Aktuator (35) in vertikaler Richtung gesehen auf der Innenseite der mehreren Speichereinheiten (34b) vorgesehen ist, wobei der Aktuator (35) so konfiguriert ist, dass er das Speicherobjekt bewegt, und
wobei der Bewegungsabschnitt (83) bewirkt, dass der Aktuator (35) die Spule (22) zum Speicherplatz (34b1, 34b2) bewegt, um darin gelagert zu werden, und die Spule (22) vom Speicherplatz (34b1, 34b2) zu der Ausgangsöffnung (30b) bewegt, um aus dem Spulenspeicherbehälter (30) entladen zu werden.

4. Speichervorrichtung (80) nach einem der Ansprüche 1 bis 3, wobei die Speichervorrichtung (80) einen Datenspeicherabschnitt (84) aufweist, der zum Abspeichern von mindestens einem Komponententyp, einer Komponentennummer und einem Ablaufdatum der auf dem um die Spule (22) gewickelten Komponentenband (21) gespeicherten Komponenten, sowie einen Spulendurchmesser und eine Spulenmenge der Spule (22), konfiguriert ist.

5. Die Speichervorrichtung (80) nach einem der Ansprüche 1 bis 4, wobei die Speichervorrichtung (80) außerdem einen Verwaltungsabschnitt (85) umfasst, der konfiguriert ist, um eine Produktion einer Komponentenmontagevorrichtung (10c) zu verwalten, die konfiguriert ist, um die Komponente, die von einer Zuführvorrichtung (24) zugeführt wird, in der die Spule (22) abnehmbar eingesetzt ist, aufzunehmen, und die Komponente auf einer Platine (90) zu montieren, und
wobei der Verwaltungsabschnitt (85) bewirkt, dass die Spule (22) unter Verwendung des Bewegungsabschnitts (83) aus dem Spulenspeicherbehälter (30) entladen wird, wenn in der Komponentenmontagevorrichtung (10c) ein Setup-Wechsel erfolgt, beim Auftreten eines Mangels an den Komponenten, die der Komponentenmontagevorrichtung (10c) zugeführt werden, oder beim Auftreten einer Möglichkeit des Auftretens der Setup-Wechsel oder des Mangels an Komponenten.

6. Speichervorrichtung (80) nach Anspruch 5, wobei der Verwaltungsabschnitt (85) bewirkt, dass ein Zuführvorrichtung-Speicherbehälter (40), in dem die Zuführvorrichtung (24) gespeichert ist, die Zuführvorrichtung (24) daraus entlädt, entsprechend einer Menge der Spulen (22), die aus dem Spulenspeicherbehälter (30) entladen sind.

7. Speichervorrichtung (80) nach Anspruch 5 oder 6, wobei der Verwaltungsabschnitt (85) das Einsetzen der Spule (22) in die Zuführvorrichtung (24) bewirkt unter Verwendung einer Spuleneinstellvorrichtung (50), die dazu konfiguriert ist, um zumindest einen Teil eines Vorgangs des Einsetzens der Spule (22) in die Zuführvorrichtung (24) auf automatisierte Weise durchzuführen.

8. Speichervorrichtung (80) nach einem der Ansprüche 5 bis 7, wobei der Verwaltungsabschnitt (85) eine Fördervorrichtung (60) verwendet, um zumindest entweder die Spule (22) oder die Zuführvorrichtung (24) zu der Komponentenmontagevorrichtung (10c) zu befördern.

9. Speichervorrichtung (80) nach Anspruch 5, wobei der Verwaltungsabschnitt (85) bewirkt, dass die Spule (22) einschließlich der Komponenten, die nicht in der Komponentenmontagevorrichtung (10c) verwendet wurden, in den Spulenspeicherbehälter (30) zurückkehrt mittels eine Fördervorrichtung (60).

10. Speichervorrichtung (80) nach Anspruch 5, wobei der Verwaltungsabschnitt (85) bewirkt, dass zumindest entweder die Zuführvorrichtung (24), in der die Spule (22) einschließlich der Komponenten, die nicht in der Komponentenmontagevorrichtung (10c) verwendet wurden, eingesetzt ist, oder die Zuführvorrichtung (24), in der die Spule (22) eingesetzt wurde, nachdem die Spule (22) in der Komponentenmontagevorrichtung (10c) verwendet wurde, zu einem Zuführvorrichtung-Speicherbehälter (40) zurückkehrt, in dem die Zuführvorrichtung (24) mittels einer Fördervorrichtung (60) gespeichert wird.

11. Speichervorrichtung (80) nach einem der Ansprüche 5 bis 10,
wobei der Speichergegenstand eine Kassette (23) einschließlich der Spule (22) ist und die Spule (22) abnehmbar in der Kassette (23) montiert ist, und
wobei der Verwaltungsabschnitt (85) Kombinationen der Spule (22), der Kassette (23) und der Zuführvorrichtung (24) und deren Standorte in Verbindung miteinander verwaltet.

12. Ein Spulenspeicherverfahren für eine Speichervorrichtung (80), umfassend:
einen Spulenspeicherbehälter (30), der konfiguriert ist, um eine erste Spule (22a), um die ein Komponentenband (21) mit Verpackungskomponenten gewickelt ist, und eine zweite Spule (22b) mit einem anderen Spulendurchmesser als die erste Spule (22a) zu speichern;
eine Spulenumspulvorrichtung (31), die im Spulenspeicherbehälter (30) vorgesehen ist; und
einen Speicherplatz (34b1, 34b2), der im Spulenspeicherbehälter (30) vorgesehen ist, um einen Speichergegenstand einschließlich der Spule (22) zu speichern, wobei das Spulenspeicherverfahren Folgendes umfasst:
einen Umspulschritt, bei dem bewirkt wird, dass das um die erste Spule (22a) gewickelte Komponentenband (21) unter Verwendung der Spulenumspulvorrichtung (31) um die zweite Spule (22b) aufgewickelt wird, wenn festgestellt wird, dass es erforderlich ist, das Komponentenband (21) um die zweite Spule (22b) aufzuwickeln, wenn die erste Spule (22a) in den Spulenspeicherbehälter (30) geladen wird, um darin gespeichert zu werden; und
einen Bewegungsschritt, bei dem die Spule (22) zum vorbestimmten Speicherplatz (34b1, 34b2) bewogen wird, um dort gespeichert zu werden, und die Spule (22), die im Speicherplatz (34b1, 34b2) gespeichert ist, zu einer Ausgangsöffnung (30b) des Spulenspeicherbehälters (30) bewogen wird, um daraus entladen zu werden, wenn die Spule (22) aus dem Spulenspeicherbehälter (30) entladen werden soll.

## Revendications

1. Dispositif de stockage (80) comprenant :
un conteneur de stockage de bobines (30) configuré pour stocker une première bobine (22a) autour de laquelle est bobinée une bande de composants (21) comportant des composants de conditionnement, ainsi qu'une seconde bobine (22b) de diamètre différent de celui de la première bobine (22a),
un dispositif de rembobinage de bobine (31) disposé dans le conteneur de stockage de bobines (30),
un espace de stockage (34b1, 34b2) disposé dans le conteneur de stockage de bobines (30) afin de stocker un objet de stockage incluant la bobine (22),
une section de rembobinage (82) configurée pour amener la bande de composants (21) bobinée autour de la première bobine (22a) à être rembobinée autour de la seconde bobine (22b) grâce à l'utilisation du dispositif de rembobinage de bobine (31) dans le cas où il serait nécessaire de rembobiner la bande de composants (21) autour de la seconde bobine (22b) lorsque la première bobine (22a) est chargée dans le conteneur de stockage de bobines (30), et
une section mobile (83) configurée pour déplacer la bobine (22) vers l'espace de stockage (34b1, 34b2) prédéterminé afin de la stocker dedans et pour déplacer la bobine (22) stockée dans l'espace de stockage (34b1, 34b2) vers un accès de départ (30b) du conteneur de stockage de bobines (30) pour qu'elle soit déchargée de celui-ci lorsque la bobine (22) doit être déchargée du conteneur de stockage de bobines (30).

2. Dispositif de stockage (80) selon la revendication 1, le dispositif de stockage (80) comprenant en outre une section de détermination de rembobinage (81) configurée pour déterminer qu'il est nécessaire de rembobiner la bande de composants (21) autour de la seconde bobine (22b) lorsque le diamètre de bobine de la première bobine (22a) diffère du diamètre de bobine qui autorise la première bobine (22a) à être placée dans un dispositif d'alimentation (24), et
dans lequel, lorsqu'il est déterminé que le rembobinage de la bande de composants (21) autour de la seconde bobine (22b) est nécessaire par la section de détermination de rembobinage (81), la section de rembobinage (82) amène la bande de composants (21) bobinée autour de la première bobine (22a) à être rembobinée autour de la seconde bobine (22b) dont le diamètre de bobine autorise la seconde bobine (22b) à être placée dans le dispositif d'alimentation (24).

3. Dispositif de stockage selon la revendication 1 ou la revendication 2, dans lequel le conteneur de stockage de bobines (30) comprend une section de stockage (34) incluant de multiples unités de stockage (34b) dans chacune desquelles de multiples espaces de stockage (34b1, 34b2) sont prévus le long de la direction verticale, les multiples unités de stockage (34b) étant disposées selon une forme circulaire comme on peut le voir dans la direction verticale,
dans lequel un actionneur (35) est prévu vers l'intérieur des multiples unités de stockage (34b) comme on peut le voir dans la direction verticale, l'actionneur (35) étant configuré pour déplacer l'objet de stockage, et
dans lequel la section mobile (83) amène l'actionneur (35) à déplacer la bobine (22) vers l'espace de stockage (34b1, 34b2) afin d'y être stockée et déplace la bobine (22) depuis l'espace de stockage (34b1, 34b2) vers l'accès de départ (30b) pour qu'elle soit déchargée du conteneur de stockage de bobines (30).

4. Dispositif de stockage (80) selon l'une quelconque des revendications 1 à 3, le dispositif de stockage (80) comportant une section de mémoire (84) configurée pour mémoriser au moins l'un parmi un type de composant, le nombre de composants et la date d'expiration des composants stockés sur la bande de composants (21) bobinée autour de la bobine (22), tout comme le diamètre de bobine et la quantité de bobines de la bobine (22).

5. Dispositif de stockage (80) selon l'une quelconque des revendications 1 à 4, le dispositif de stockage (80) comprenant en outre une section de gestion (85) configurée pour gérer la fabrication d'un dispositif de montage de composants (10c) configuré pour prélever le composant délivré par un dispositif d'alimentation (24) sur lequel est montée de façon amovible la bobine (22), et pour monter le composant sur une carte (90), et
dans lequel la section de gestion (85) amène le déchargement de la bobine (22) du conteneur de stockage de bobines (30) grâce à l'utilisation de la section mobile (83) à l'apparition d'un basculement de configuration dans le dispositif de montage de composants (10c), à l'apparition d'une pénurie de composants délivrés au dispositif de montage de composants (10c) ou encore à l'apparition de la possibilité d'apparition du basculement de configuration ou de la pénurie de composants.

6. Dispositif de stockage (80) selon la revendication 5, dans lequel la section de gestion (85) amène un conteneur de stockage de dispositifs d'alimentation (40) où est stocké le dispositif d'alimentation (24) à décharger le dispositif d'alimentation (24) en fonction de la quantité de bobines (22) déchargées du conteneur de stockage de bobines (30).

7. Dispositif de stockage (80) selon la revendication 5 ou la revendication 6, dans lequel la section de gestion (85) amène le montage de la bobine (22) dans le dispositif d'alimentation (24) grâce à l'utilisation d'un dispositif de montage de bobines (50) configuré pour effectuer au moins une partie d'une opération de montage automatique de la bobine (22) dans le dispositif d'alimentation (24).

8. Dispositif de stockage (80) selon l'une quelconque des revendications 5 à 7, dans lequel la section de gestion (85) utilise un dispositif de transport (60) pour transporter au moins l'un ou l'autre de la bobine (22) et du dispositif d'alimentation (24) vers le dispositif de montage de composants (10c).

9. Dispositif de stockage (80) selon la revendication 5, dans lequel la section de gestion (85) amène le retour de la bobine (22) comprenant les composants qui n'ont pas été utilisés dans le dispositif de montage de composants (10c) vers le conteneur de stockage de bobines (30) grâce à l'utilisation du dispositif de transport (60).

10. Dispositif de stockage (80) selon la revendication 5, dans lequel la section de gestion (85) amène au moins le retour de l'un ou l'autre du dispositif d'alimentation (24) sur lequel est montée la bobine (22) comprenant les composants qui n'ont pas été utilisés dans le dispositif de montage de composants (10c) et du dispositif d'alimentation (24) dans lequel la bobine (22) a été montée après que la bobine (22) a été utilisée dans le dispositif de montage de composants (10c) vers un conteneur de stockage de dispositifs d'alimentation (40) où est stockée le dispositif d'alimentation (24) grâce à l'utilisation d'un dispositif de transport (60).

11. Dispositif de stockage (80) selon l'une quelconque des revendications 5 à 10,
dans lequel l'objet de stockage est une cassette (23) incluant la bobine (22), et la bobine (22) est montée de façon amovible dans la cassette (23), et
dans lequel la section de gestion (85) gère des combinaisons de la bobine (22), de la cassette (23) et du dispositif d'alimentation (24) ainsi que leurs emplacements en association les uns avec les autres.

12. Procédé de stockage de bobines destinées à un dispositif de stockage (80) comprenant :
un conteneur de stockage de bobines (30) configuré pour stocker une première bobine (22a) autour de laquelle est bobinée une bande de composants (21) comportant des composants de conditionnement, ainsi qu'une seconde bobine (22b) de diamètre différent de celui de la première bobine (22a),
un dispositif de rembobinage de bobine (31) disposé dans le conteneur de stockage de bobines (30),
un espace de stockage (34b1, 34b2) disposé dans le conteneur de stockage de bobines (30) afin de stocker un objet de stockage incluant la bobine (22), le procédé de stockage de bobines comprenant :
une étape de rembobinage consistant à amener la bande de composants (21) bobinée autour de la première bobine (22a) à être rembobinée autour de la seconde bobine (22b) grâce à l'utilisation du dispositif de rembobinage de bobine (31) dans le cas où il est déterminé qu'il serait nécessaire de rembobiner la bande de composants (21) autour de la seconde bobine (22b) lorsque la première bobine (22a) est chargée dans le conteneur de stockage de bobines (30) pour y être stockée, et
une étape de consistant à déplacer la bobine (22) vers l'espace de stockage (34b1, 34b2) prédéterminé afin de la stocker dedans et pour déplacer la bobine (22) stockée dans l'espace de stockage (34b1, 34b2) vers un accès de départ (30b) du conteneur de stockage de bobines (30) pour qu'elle soit déchargée de celui-ci lorsque la bobine (22) doit être déchargée du conteneur de stockage de bobines (30).
